# EUROPEAN PATENT APPLICATION

(11) **EP 4 576 455 A1**
(43) Date of publication of application: **25.06.2025**
(21) Application number: 24205400.5
(22) Date of filing: 08.10.2024
(51) Int. Cl.: H01S 5/042, H01S 5/40, H01S 5/42, H01S 5/183

(54) **A MONOLITHIC INTEGRATED CIRCUIT LASER MULTIPLEXER**

(30) Priority: 19.12.2023 US 202318545269
(71) Applicant: II-VI Delaware, Inc., Wilmington, DE 19890 (US)
(72) Inventor: SHOKRANI, Mohsen, Wilmington, 19890 (US); KOUWENHOVEN, Michiel, Wilmington, 19890 (US); AHMARI, David, Wilmington, 19890 (US); CHEN, Young-Kai, Wilmington, 19890 (US)
(74) Representative: Schmidt, Christian

(57) **Abstract**

Embodiments of the present disclosure may comprise a monolithic integrated circuit device comprising an addressable laser array, where the addressable laser array comprises a plurality of N light-emitting sources. Embodiments may also comprise a multiplexer including N transistors, where each of the N transistors are associated with a different one of the plurality of N light-emitting sources. In accordance with various embodiments, each of the N transistors may be operable to address the associated light-emitting source.

## Description

### TECHNICAL FIELD

The present disclosure generally relates to a monolithic integrated circuit laser multiplexer.

### BACKGROUND

Aspects of the present disclosure relate to a monolithic integrated circuit laser multiplexer. Various issues may exist with conventional solutions for monolithic integrated circuit laser multiplexer. In this regard, conventional systems and methods for a monolithic integrated circuit laser multiplexer may be costly, cumbersome, and/or inefficient.

Limitations and disadvantages of conventional systems and methods will become apparent to one of skill in the art, through comparison of such approaches with some aspects of the present methods and systems set forth in the remainder of this disclosure with reference to the drawings.

### BRIEF SUMMARY OF THE DISCLOSURE

Shown in and/or described in connection with at least one of the figures, and set forth more completely in the claims, is a monolithic integrated circuit laser multiplexer.

These and other advantages, aspects and novel features of the present disclosure, as well as details of illustrated embodiments thereof, will be more fully understood from the following description and drawings.

### BRIEF DESCRIPTION OF THE DRAWINGS

The various features and advantages of the present disclosure may be more readily understood with reference to the following detailed description taken in conjunction with the accompanying drawings, wherein like reference numerals designate like structural elements.
FIG. 1 is a block diagram illustrating a monolithic integrated circuit laser multiplexer, according to some embodiments of the present disclosure.
FIG. 2 illustrates an exemplary schematic of a monolithic integrated circuit device 100, in accordance with various embodiments of the present disclosure.
FIG. 3 illustrates a further exemplary schematic of a monolithic integrated circuit device 100, in accordance with various embodiments of the present disclosure.
FIG. 4 illustrates an exemplary structure of a multiplexer 114 using pHEMTs.
FIG. 5 illustrates an exemplary structure of a multiplexer 114 using HBTs.
FIG. 6 illustrates an exemplary monolithic GaAs VCSEL - pHEMT structure.
FIG. 7 illustrates an exemplary monolithic GaAs VCSEL - HBT structure.
FIG. 8 is a block diagram that further describes the monolithic integrated circuit device.
FIG. 9 is a block diagram that further describes the monolithic integrated circuit device.
FIG. 10 is a block diagram that further describes the monolithic integrated circuit device.

### DETAILED DESCRIPTION

The following discussion provides various examples of method and system for a monolithic integrated circuit laser multiplexer. Such examples are non-limiting, and the scope of the appended claims should not be limited to the particular examples disclosed. In the following discussion, the terms "example" and "e.g.," are non-limiting.

The figures illustrate the general manner of construction, and descriptions and details of well-known features and techniques may be omitted to avoid unnecessarily obscuring the present disclosure. In addition, elements in the drawing figures are not necessarily drawn to scale. For example, the dimensions of some of the elements in the figures may be exaggerated relative to other elements to help improve understanding of the examples discussed in the present disclosure. The same reference numerals in different figures denote the same elements.

The term "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z".

The terms "comprises," "comprising," "comprises," and/or "including," are "open ended" terms and specify the presence of stated features, but do not preclude the presence or addition of one or more other features.

The terms "first," "second," etc. may be used herein to describe various elements, and these elements should not be limited by these terms. These terms are only used to distinguish one element from another. Thus, for example, a first element discussed in this disclosure could be termed a second element without departing from the teachings of the present disclosure.

Unless specified otherwise, the term "coupled" may be used to describe two elements directly contacting each other or describe two elements indirectly connected by one or more other elements. For example, if element A is coupled to element B, then element A can be directly contacting element B or indirectly connected to element B by an intervening element C. Similarly, the terms "over" or "on" may be used to describe two elements directly contacting each other or describe two elements indirectly connected by one or more other elements.

Embodiments of the present disclosure may comprise a monolithic integrated circuit device comprising an addressable laser array, the addressable laser array comprising a plurality of N light-emitting sources. Embodiments may also comprise a multiplexer comprising N transistors, each of the N transistors associated with a different one of the plurality of N light-emitting sources. In accordance with various embodiments, each of the N transistors may be operable to address the associated one light-emitting source.

Embodiments may comprise each of the plurality of N light-emitting sources may be an LED, an EEL, a VCSEL, or a PCSEL. In accordance with various embodiments, the monolithic integrated circuit may comprise a substrate / wafer made of GaN, GaAs, InP, SiC, or GaSb. Embodiments may also comprise each of the plurality of N transistors may be a MESFET, pHEMT, HFET, or HBT that may be operable for 3-terminal analog functionality.

In accordance with various embodiments, the monolithic integrated circuit may comprise a plurality of epitaxial layers operable to form the light-emitting sources and the transistors. In accordance with various embodiments, the epitaxial layers used to form the light-emitting sources may be isolated form the epitaxial layers used to form the transistors by one or more epitaxial layers of highly resistive GaAs and/or InGaP.

In accordance with various embodiments, the InGaP layer may be operable to stop etching between one or more epitaxial layers associated with the plurality of light-emitting sources and one or more epitaxial layers associated with the plurality of transistors. In accordance with various embodiments, the epitaxial layers used to form the light-emitting sources may be different from the epitaxial layers used to form the transistors. An etch stop layer may also be made from AlAs or AlGaAs. In accordance with various embodiments, instead of an etch-stop layer, a timed-etch fabrication process may be used. A timed-etch fabrication process may refer to the controlled removal of material from the surface of a semiconductor wafer using a chemical etchant for a specified duration, in order to etch away material with precision. The process may be governed by a predetermined etch rate, i.e., the volume of material removed per unit time.

In accordance with various embodiments, the epitaxial layers associated with the transistors may overlay the epitaxial layers associated with the light-emitting sources. Embodiments may also comprise an epitaxial structure of the plurality of N light-emitting sources that may comprise a smoothing buffer layer, an N-type DBR layer, one or more active layers, and a P-type DBR layer.

In accordance with various embodiments, the smoothing buffer layer, the N-type DBR layer, the one or more active layers, and the P-type DBR layer each may comprise a plurality of epitaxial layers. Embodiments may also comprise an epitaxial structure of the plurality of N transistors that may comprise one or more single recess pHEMTs.

Embodiments may also comprise an epitaxial structure of the plurality of N transistors that may comprise one or more double recess pHEMTs. Embodiments may also comprise a lower barrier layer. Embodiments may also comprise a lower delta doped layer. Embodiments may also comprise a lower spacer layer. Embodiments may also comprise a channel layer. Embodiments may also comprise an upper spacer layer. Embodiments may also comprise an upper delta doped layer. Embodiments may also comprise an upper barrier layer. Embodiments may also comprise a Schottky layer. Embodiments may also comprise a recess layer. Embodiments may also comprise an etch stop layer. Embodiments may also comprise a cap layer.

Embodiments may also comprise an epitaxial structure of the plurality of N transistors that may comprise HBTs. Embodiments may comprise a sub collector layer, a collector layer, a base layer, an emitter layer and/or an emitter cap layer. In accordance with various embodiments, the transistors may be isolated from the light-emitting sources by ion implantation and/or mesa etching.

Traditionally, lasers may often be driven by external driver circuits. This approach may not allow optimal switching speeds. If one may desire a chip with individually addressable lasers or sub-arrays, such an approach may be costly and of an inconvenient form factor. The present disclosure monolithically integrates an analog multiplexer function on a laser chip so that it may be efficiently driven by a circuit. In accordance with various embodiments of the present disclosure, a triode laser functionality may be monolithically integrated on-chip, useful for laser arrays.

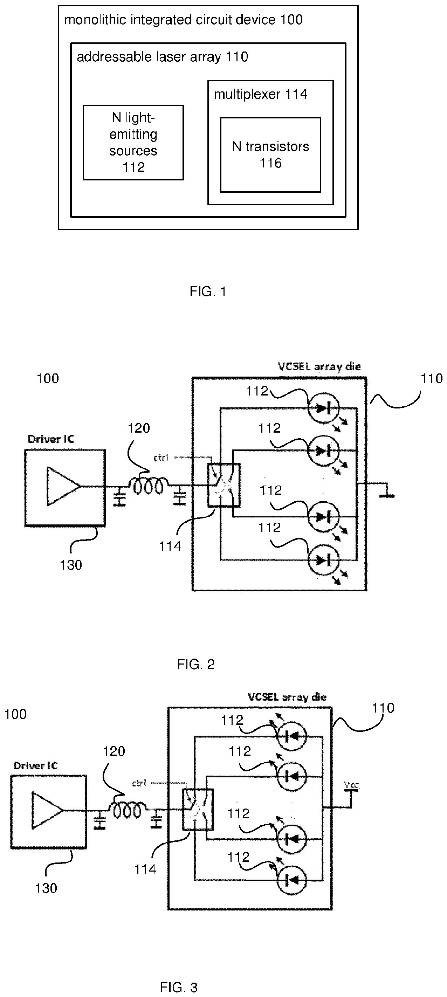

FIG. 1 is a block diagram that describes a monolithic integrated circuit device 100, according to some embodiments of the present disclosure. In some embodiments, the monolithic integrated circuit device 100 may include an addressable laser array 110. The addressable laser array 110 may include a plurality of N light-emitting sources 112 and a multiplexer 114. The multiplexer 114 may also include N transistors 116, each of the N transistors 116 associated with a different one of the plurality of N light-emitting sources 112. Each of the N transistors 116 may be operable to address the associated one light-emitting source 112.

The monolithic integrated circuit device 100 may be operable as an electronic circuit integrated onto a single semiconductor substrate and may be operable as a component housing further elements on the semiconductor. The addressable laser array 110 may be operable to activate laser sources, for example light-emitting sources 112, selectively. Each light-emitting source 112 in the addressable laser array 110 may be controlled individually. The light emitting sources 112 may be operable to emit light, for example using laser light sources. The multiplexer 114 may be operable to manage, address and control the plurality of light-emitting sources 112. Each light emitting source 112 may be associated with a transistor 116 forming part of the multiplexer 114. The transistors 116 may allow for individual control of light emitting sources 112.

FIG. 2 illustrates an exemplary schematic of a monolithic integrated circuit device 100, in accordance with various embodiments of the present disclosure. In addition to the elements shown in FIG. 1, FIG. 2 further comprises a control interface 120 and a driver 130. The control interface 120 may be coupled between the driver 130 and the multiplexer 114. The driver 130 may be operable to supply power to the light-emitting sources 112. The control interface 120 may generally be a bandwidth-limited and time-sensitive interface. It may thus be desirable to reduce the number of control interfaces 120. According to various embodiments of the present disclosure, it is preferable to use a single control interface 120 and then use multiplexer 114 to select a desired light-emitting source 112 instead of addressing each light-emitting source 112 individually with a control interface 120.

FIG. 3 illustrates a further exemplary schematic of a monolithic integrated circuit device 100, in accordance with various embodiments of the present disclosure.

In some embodiments, each of the plurality of N light-emitting sources 112 may be an LED, an EEL, a VCSEL, or a PCSEL.

An LED may be a light emitting diode. An LED may be a semiconductor light source that may emit light when current flows through it. This may occur due to a process known as electroluminescence, wherein the movement of electrons in the semiconductor material may release energy in the form of photons. LED's may be highly efficient, durable, and offer a long operational lifespan. LEDs may be widely used in a variety of applications, for example displays or indicators. LEDs may have low energy consumption and low heat generation.

An EEL may be an Edge-Emitting Laser. An Edge-Emitting Laser (EEL) may be a type of semiconductor laser where light may be emitted from the edge of the semiconductor chip, rather than the surface. EELs may often be used in applications that require higher output power and longer coherence length. EELs may often be employed in telecommunications and high-speed data transmission due to their capacity to produce highly collimated, or parallel, beams of light.

A VCSEL may be a Vertical-Cavity Surface-Emitting Laser. A VCSEL may be a type of semiconductor laser diode that emits light perpendicular to the surface of the wafer, rather than from its edge. The distinguishing feature of a VCSEL may be its vertical cavity structure, which may be formed by Bragg mirrors. VCSELs may provide low manufacturing costs, high efficiency, and the ability to be easily tested and configured into two-dimensional arrays. They may be commonly used in optical communication, sensing applications, and consumer electronics.

A PCSEL may be a Photonic Crystal Surface-Emitting Laser. A PCSEL may be a laser that leverages the properties of photonic crystals to control the emission of light. Photonic crystals may be optical materials that have a periodic structure on the scale of the wavelength of light. This may permit PCSELs to produce highly directional and coherent light beams. Their structure enables greater control over the laser's optical characteristics, which may make them desirable for specialized applications such as high-density data storage and advanced optical communications.

In some embodiments, the monolithic integrated circuit may also include a substrate /wafer made of GaN, GaAs, InP, SiC, or GaSb.

GaN may refer to Gallium Nitride. Gallium Nitride may be a binary III-V direct bandgap semiconductor material that may possess high electron mobility and thermal stability. As a substrate in monolithic integrated circuits, GaN may be particularly useful for high-frequency and high-power applications such as radio frequency components and power electronics. Its wide bandgap, high breakdown field, and thermal conductivity may make it a desirable choice for devices that may be required to operate in extreme conditions, such as high-temperature and high-voltage environments.

GaAs may refer to Gallium Arsenide. Gallium Arsenide may be another III-V compound semiconductor with a direct bandgap, known for its higher electron mobility compared to silicon. In the context of monolithic integrated circuits, GaAs may be used in applications requiring high-frequency operation and low-noise amplification, for example. This may include microwave and millimeter-wave technology applications. Its high electron mobility may allow for fast electronic components.

InP may refer to Indium Phosphide. Indium Phosphide may be a binary semiconductor composed of indium and phosphorus, belonging to the III-V group of semiconductors. It may have a direct bandgap and possesses high electron mobility and large intrinsic resistivity. InP substrates may be used frequently in optoelectronic devices like high-speed photodetectors and lasers, as well as in high-frequency integrated circuits. It may offer advantages in terms of low noise and high frequency capabilities.

SiC may refer to Silicon Carbide. Silicon Carbide may be a wide-bandgap semiconductor material that is particularly hard, chemically inert, and thermally stable. In the realm of monolithic integrated circuits, SiC may be highly valued for high-power, high-temperature, and high-frequency applications. Its wide bandgap and high thermal conductivity may make it a desirable substrate material for power electronics, including high-voltage transistors and diodes, especially in environments where high temperatures or high frequencies are prevalent.

GaSb may refer to Gallium Antimonide. Gallium Antimonide may be a III-V compound semiconductor with a narrower bandgap than GaAs or GaN. As a substrate material in monolithic integrated circuits, GaSb may be desirable for infrared photodetectors and thermophotovoltaic devices. Its bandgap may make it advantageous for specialized applications in optoelectronics and for devices that operate in the mid-infrared wavelength range.

In some embodiments, each of the plurality of N transistors may be a MESFET, pHEMT, HFET, or HBT that may be operable for 3-terminal analog functionality.

MESFET may refer to Metal-Semiconductor Field-Effect Transistors. MESFET may be a field-effect transistor that uses a metal-semiconductor junction (Schottky barrier) as the gate. This type of transistor may be commonly fabricated using compound semiconductors like GaAs or SiC, and may be desirable for use in microwave and radiofrequency (RF) applications. The MESFET's high electron mobility and low parasitic capacitance make it particularly advantageous in high-frequency, high-power, and low-noise applications such as radar systems and satellite communications.

pHEMT may refer to Pseudomorphic High Electron Mobility Transistor. A pHEMT may be a specialized type of field-effect transistor that features a higher concentration of charge carriers. This may allow for increased electron mobility and desirable performance. The pHEMT may be used predominantly in high-frequency and low-noise applications, such as RF amplifiers because of its desirable high-frequency characteristics.

HFET may refer to Heterostructure Field-Effect Transistors. HFET may also be referred to as HEMT (High Electron Mobility Transistor), although HFETs may comprise different types of heterostructure transistors. HFETs may employ a heterostructure to create a channel with high electron mobility, making them suitable for high-frequency and high-power applications. They may be used in telecommunications, broadband amplifiers, and other applications requiring high-speed operation, for example.

HBT may refer to Heterojunction Bipolar Transistor. HBT may be a type of bipolar transistor that may employ differing semiconductor materials for the emitter and base regions, creating a heterojunction. This may permit improved performance, including higher speed and efficiency compared to traditional bipolar transistors. HBTs may be used commonly in high-frequency applications such as RF and microwave circuits. They may also be used in optoelectronics, where their high current densities may be advantageous for laser drivers and photodetectors.

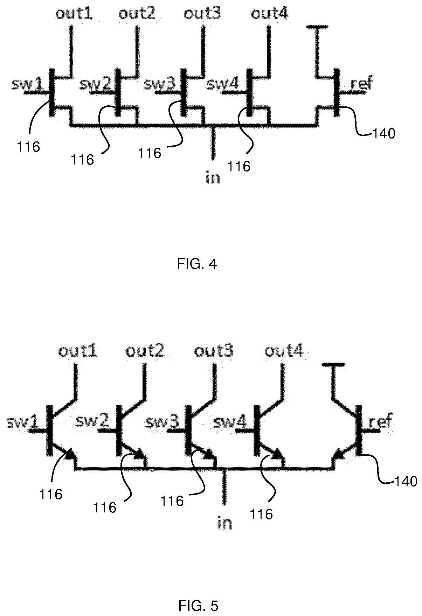

FIG. 4 illustrates an exemplary structure of a multiplexer 114 using pHEMTs. There is shown a plurality of pHEMTs 116 that may switch an "in" signal to one of four output signals labeled "out1", "out2", "out3", "out4". In accordance with various embodiments of the present disclosure, such a multiplexer 114 may be used in a monolithic integrated circuit 100 as illustrated in FIG. 2. There is also shown a reference switch 140.

The reference switch 140 may be used to provide a consistent voltage or current level against which the other inputs may be compared. This may be desirable to ensure that the switching operates correctly and that there may be minimal crosstalk or interference between channels. In some instances, the reference switch 140 may be used as a safety or calibration point. For example, when no other switches may be activated, the reference switch 140 might engage to ensure that no laser may be activated unintentionally. In other instances, the reference switch 140 may be used to monitor the multiplexer 114.

FIG. 5 illustrates an exemplary structure of a multiplexer 114 using HBTs. There is shown a plurality of HBTs 116 that may switch an "in" signal to one of four output signals labeled "out1", "out2", "out3", "out4". In accordance with various embodiments of the present disclosure, such a multiplexer 114 may be used in a monolithic integrated circuit 100 as illustrated in FIG. 3.

In some embodiments, the monolithic integrated circuit may include a plurality of epitaxial layers operable to form the light-emitting sources 112 and the transistors 116.

Epitaxial layers may refer to layers of crystalline semiconductor material that may be grown on a crystalline semiconductor substrate. The ordered growth of the epitaxial layer in alignment with the crystalline structure of the substrate may ensure that the epitaxial layer inherits the same crystalline structure as the underlying substrate.

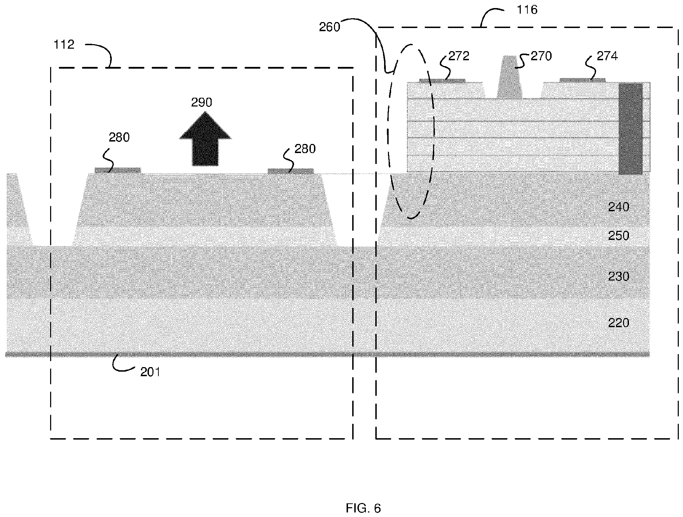

FIG. 6 illustrates an exemplary monolithic GaAs VCSEL - pHEMT structure. There is shown a cross-section of semiconductor layers comprising a pHEMT 116 and a VCSEL laser light-emitting source 112. For the VCSEL light-emitting source 112, there is further shown a direction of emitted light 290, anodes 280, a cathode 201, a smoothing buffer layer 220, an N-type DBR (Distributed Bragg Reflector) layer 230, active layer 250, and a P-type DBR layer 240. For the pHEMT 116, there is shown epitaxial layers 260, a source connector 272, a gate connector 270, and the drain connector 274.

The VCSEL light-emitting source 112 comprise N-type DBR layer 230 and P-type DBR layer 240 that may act as mirrors, forming the laser cavity's top and bottom. The active layer 250 is where the light generation and amplification may occur.

The pHEMT 116 may be formed by the epitaxial layers 260. The epitaxial layers 260 may comprise a channel that may be made from InGaAs. This layer may be strained, resulting in enhanced electron mobility. Further, the epitaxial layers 260 may comprise a barrier layer, for example a layer of AlGaAs or AIGalnAs, that may form a heterojunction with the channel. Further, the epitaxial layers 260 may comprise one or more layers, made of doped GaAs, for example.

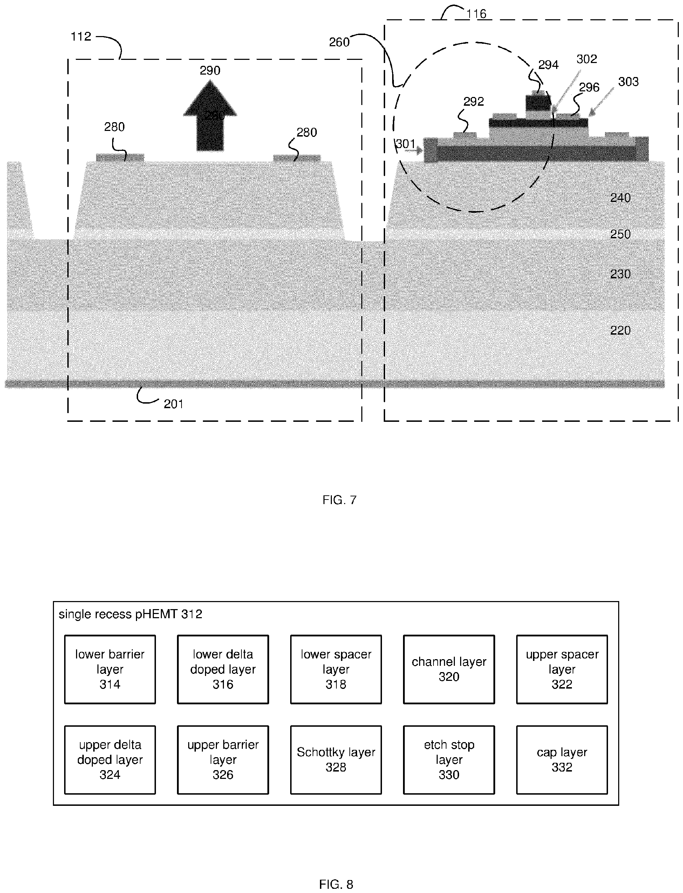

In some embodiments, the epitaxial layers used to form the light-emitting sources 112 may be isolated from the epitaxial layers used to form the transistors 116 by one or more epitaxial layers of highly resistive GaAs (Gallium Arsenide) and/or InGaP (Indium Gallium Phosphide). For example, in FIG. 6, one or more highly resistive epitaxial layers 260 may be located adjacent to the P-type DBR layer 240. In FIG. 7, for example, a highly resistive InGaP layer may be immediately adjacent to the P-type DBR layer 240. In accordance with various embodiments, an etch stop layer of an HBT as shown in FIG. 7 may be conductive or resistive. In some embodiments, the highly resistive InGaP layer may also stop etching between one or more epitaxial layers of the transistors. An etch stop layer may also be made from AlAs or AlGaAs. In accordance with various embodiments, instead of an etch-stop layer, a timed-etch fabrication process may be used.

FIG. 7 illustrates an exemplary monolithic GaAs VCSEL - HBT structure. There is shown a cross-section of semiconductor layers comprising an HBT 116 and a VCSEL laser light-emitting source 112. For the VCSEL light-emitting source 112, there is further shown a direction of emitted light 290, anodes 280, a cathode 201, a smoothing buffer layer 220, an N-type DBR (Distributed Bragg Reflector) layer 230, active layer 250, and a P-type DBR layer 240. For the HBT 116, there is shown epitaxial layers 260, a collector connector 292, a base connector 296, and an emitter connector 294. Further, there is shown an isolation layer 301, an emitter 302 (for example an InGaP emitter), and base 303 (for example a GaAs base).

In some embodiments, an InGaP layer may be operable to stop etching between one or more epitaxial layers associated with the plurality of light-emitting sources 112 and one or more epitaxial layers 260 associated with the plurality of transistors. An etch stop layer may also be made from AlAs or AlGaAs. In accordance with various embodiments, instead of an etch-stop layer, a timed-etch fabrication process may be used.

In some embodiments, the epitaxial layers used to form the light-emitting sources 112 may be different from the epitaxial layers used to form the transistors 116, as illustrated in FIG. 6 and FIG. 7. In some embodiments, the epitaxial layers associated with the transistors 116 may overlay the epitaxial layers associated with the light-emitting sources 112. In some embodiments, the transistors 116 may be isolated from the light-emitting sources 112 by ion implantation and/or mesa etching. In accordance with various embodiments of the present disclosure, the light-emitting sources 112 may comprise comprises a smoothing buffer layer 220, an N-type DBR layer 230, one or more active layers 250, and a P-type DBR layer 240.

FIG. 8 is a block diagram that further describes the monolithic integrated circuit device 100 from FIG. 1 and FIG. 6, according to some embodiments of the present disclosure. In some embodiments, an epitaxial structure of the plurality of N transistors 116 may comprise one or more single recess pHEMTs 312. The one or more single recess pHEMTs 312 may comprise a lower barrier layer 314, a lower delta doped layer 316, a lower spacer layer 318, a channel layer 320, an upper spacer layer 322, an upper delta doped layer 324, an upper barrier layer 326, a Schottky layer 328, an etch stop layer 330, and a cap layer 332.

The delta doped layers 324 and 316 may be layers that comprise a sharp concentration of dopants within a narrow region. The delta doped layers 324 and 316 may be made of a suitable dopant material, for example Silicon. In accordance with various embodiments, a pHEMT 312 may be formed without an upper delta doped layer 324.

The Schottky layer 328 may refer to the region near the interface of a Schottky barrier that may form when a metal comes into contact with a semiconductor, for example between the metal gate and the underlying semiconductor material in a pHEMT.

Spacer layers 318, 322 may be operable to provide electron separation in the electron gas channel from their donor atoms in the delta-doped layers 316, 324. This may reduce scattering and improve electron mobility. The spacer layer may also contribute to the confinement of the electrons in the quantum well, ensuring that they remain in the high-mobility channel. The spacer layers 318, 322 may be made from AlGaAs or InAIAs, for example.

In the context of a pHEMT 312, single recess may refer to a fabrication step where a portion of the semiconductor layers above the two-dimensional electron gas channel may be etched away ("recessed") to define and optimize the gate region. This recessing process may be executed to reduce the thickness of the barrier layer right beneath the metal gate contact, which in turn affects the Schottky barrier height and may permit for better control over the threshold voltage and transconductance of the device.

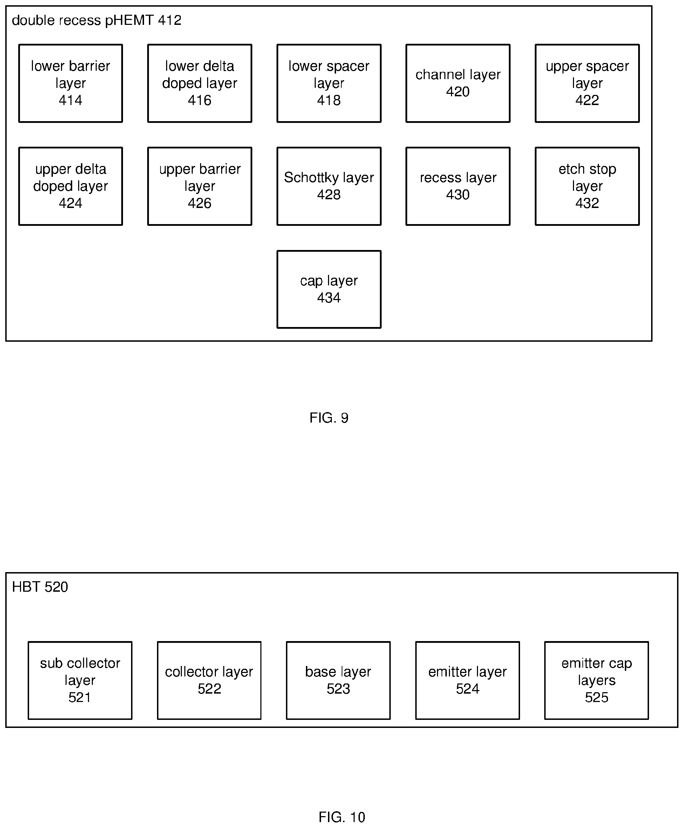

FIG. 9 is a block diagram that further describes the monolithic integrated circuit device 100 from FIG. 1 and FIG. 6, according to some embodiments of the present disclosure. In some embodiments, an epitaxial structure of the plurality of N transistors 116 may comprise one or more double recess pHEMTs 412. The one or more double recess pHEMTs 412 may comprise a lower barrier layer 414, a lower delta doped layer 416, a lower spacer layer 418, a channel layer 420, an upper spacer layer 422, an upper delta doped layer 424, an upper barrier layer 426, a Schottky layer 428, a recess layer 430, an etch stop layer 432, and a cap layer 434. These layers may be similar to those described for FIG. 8.

In the context of a pHEMT 412, double recess may be contrasted to single recess described for FIG. 8 in that multiple distinct recess etching steps may be performed on different layers or regions of the device to achieve specific device characteristics.

The recess process may enhance the overall performance of the pHEMT by allowing for a more precise control over the channel's electron density and thus improving the device's RF performance, power handling, and linearity. The recess layer 430 may refer to a layer affected by the recessing steps, for example gate recess or channel recess.

FIG. 10 is a block diagram that further describes the monolithic integrated circuit device 100 from FIG. 1 and FIG. 7, according to some embodiments of the present disclosure. In some embodiments, an epitaxial structure of the transistors 116 may comprise HBTs 520. HBTs 520 may comprise a sub collector layer 521, a collector layer 522, a base layer 523, an emitter layer 524, and one or more emitter cap layer 525.

The sub collector layer 521 may comprise, for example, Sl GaAs or InGaP. The collector layer 522 may comprise, for example, GaAs. The base layer 523 may comprise, for example, GaAs. The emitter layer 524 may comprise, for example, InGaP. The emitter cap layer 525 may comprise, for example InGaAs.

In some embodiments, the transistors 116 are isolated from the light-emitting sources 112 by ion implantation and/or mesa etching.

The present disclosure claims priority of U.S. Patent Application No. 18/545,269 filed December 19, 2023. The entire disclosure of this application is hereby explicitly incorporated by reference into the present disclosure.

Embodiments of the present disclosure may comprise a monolithic integrated circuit device comprising an addressable laser array, where the addressable laser array comprises a plurality of N light-emitting sources. Embodiments may also comprise a multiplexer including N transistors, where each of the N transistors are associated with a different one of the plurality of N light-emitting sources. In accordance with various embodiments, each of the N transistors may be operable to address the associated light-emitting source.

The present disclosure comprises reference to certain examples; however, it will be understood by those skilled in the art that various changes may be made and equivalents may be substituted without departing from the scope of the disclosure. In addition, modifications may be made to the disclosed examples without departing from the scope of the present disclosure. Therefore, it is intended that the present disclosure not be limited to the examples disclosed, but that the disclosure will comprise all examples falling within the scope of the appended claims.

## Claims

1. A monolithic integrated circuit device comprising an addressable laser array, said addressable laser array comprising:
a plurality of N light-emitting sources;
a multiplexer comprising N transistors, each of said N transistors associated with a different one of said plurality of N light-emitting sources; and
wherein each of said N transistors is operable to address said associated one light-emitting source.

2. The device according to claim 1, wherein each of said plurality of N light-emitting sources is an LED, an EEL, a VCSEL, or a PCSEL.

3. The device according to claim 1 or 2, wherein said monolithic integrated circuit comprises a substrate /wafer made of GaN, GaAs, InP, SiC, or GaSb.

4. The device according to any one of claims 1 to 3, wherein each of said plurality of N transistors is a MESFET, pHEMT, HFET, or HBT that is operable for 3-terminal analog functionality.

5. The device according to any one of claims 1 to 4, wherein said monolithic integrated circuit comprises a plurality of epitaxial layers operable to form said light-emitting sources and said transistors.

6. The device according to claim 5, wherein said epitaxial layers used to form said light-emitting sources are isolated form said epitaxial layers used to form said transistors by one or more epitaxial layers of highly resistive GaAs and/or InGaP.

7. The device according to claim 5 or 6, wherein said epitaxial layers used to form said light-emitting sources are different from said epitaxial layers used to form said transistors.

8. The device according to any one of claims 1 to 7, wherein an epitaxial structure of said plurality of N light-emitting sources comprises a smoothing buffer layer, an N-type DBR layer, one or more active layers, and a P-type DBR layer.

9. The epitaxial structure of claim 8, wherein said smoothing buffer layer, said N-type DBR layer, said one or more active layers, and said P-type DBR layer each comprise a plurality of epitaxial layers.

10. The device according to any one of claims 1 to 9, wherein an epitaxial structure of said plurality of N transistors comprises one or more single recess pHEMTs that comprise a lower barrier layer, a lower delta doped layer, a lower spacer layer, a channel layer, an upper spacer layer, an upper delta doped layer, an upper barrier layer, a Schottky layer, an etch stop layer and a cap layer.

11. The device according to any one of claims 1 to 10, wherein an epitaxial structure of said plurality of N transistors comprises one or more double recess pHEMTs that comprise a lower barrier layer, a lower delta doped layer, a lower spacer layer, a channel layer, an upper spacer layer, an upper delta doped layer, an upper barrier layer, a Schottky layer, a recess layer, an etch stop layer and a cap layer.

12. The device according to any one of claims 1 to 11, wherein an epitaxial structure of said plurality of N transistors comprise HBTs that comprise a sub collector layer, a collector layer, a base layer, an emitter layer, and emitter cap layers.

13. The device according to claim 6 or 7 or of any one of claims 8 to 12 with additional reference to claim 6 or 7, wherein said InGaP layer is operable to stop etching between one or more epitaxial layers associated with said plurality of light-emitting sources and one or more epitaxial layers associated with said plurality of transistors.

14. The device according to any one of claims 5 to 7 or of any one of claims 8 to 13 with additional reference to any one of claims 5 to 7, wherein said epitaxial layers associated with said transistors overlay said epitaxial layers associated with said light-emitting sources.

15. The device according to any one of claims 1 to 14, wherein said transistors are isolated from said light-emitting sources by ion implantation and/or mesa etching.
